# EUROPÄISCHE PATENTSCHRIFT

(11) **EP 3 560 307 B1**
(45) Veröffentlichungstag und Bekanntmachung des Hinweises auf die Patenterteilung: **16.04.2025**
(21) Anmeldenummer: 17811461.7
(22) Anmeldetag: 20.11.2017
(51) Int. Cl.: H05K 7/14

(54) **HALTERAHMEN ZUM ANBRINGEN EINER LEITERPLATTE AN EINEM GEHÄUSE**
HOLDING FRAME FOR ATTACHING A PRINTED CIRCUIT BOARD TO A HOUSING
CADRE DE MAINTIEN SERVANT AU MONTAGE D'UNE CARTE DE CIRCUIT IMPRIMÉ SUR UN BOÎTIER

(30) Priorität: 21.12.2016 DE 102016225762
(43) Veröffentlichungstag der Anmeldung: 30.10.2019
(73) Patentinhaber: Robert Bosch GmbH, 70442 Stuttgart (DE)
(72) Erfinder: MERZ, Harald, 76547 Sinzheim (DE)
(86) Internationale Anmeldenummer: PCT/EP2017/079703
(87) Internationale Veröffentlichungsnummer: WO 2018/114164

(56) Entgegenhaltungen:
- WO-A1-01/87029
- WO-A2-2007/033849
- CH-A5- 649 884
- DE-A1- 102008 043 457
- US-A- 5 174 780
- US-B1- 7 040 905

## Beschreibung

### Technisches Gebiet

Die Erfindung betrifft einen Halterahmen zum Anbringen einer Leiterplatte an einem Gehäuse, insbesondere innerhalb eines Gehäuses. Ferner betrifft die Erfindung ein entsprechendes Befestigungssystem für eine Leiterplatte, das einen derartigen Halterahmen und ein Gehäuse umfasst. Dabei richtet sich die Erfindung insbesondere auf die Art der Befestigung des Halterahmens am Gehäuse

### Stand der Technik

Leiterplatten, die auch als Elektronikplatten (Englisch: printed circuit board, insbesodere electronic control unit) bezeichnet werden, können an einem Metallgehäuse angeschraubt oder an einem Kunststoffgehäuse mittels Rasthaken befestigt werden. Die Befestigung mittels Rasthaken wird auch als Schnappverbindung oder Einklipsen bezeichnet. Es ist ferner bekannt, Leiterplatten in einem Gehäuse mittels eines Kunststoffträgers mit Rasthaken zu befestigen.

So ist aus der Druckschrift EP 2 814 309 A2 ein Halterahmen für eine Leiterplatte bekannt, der beispielsweise aus Kunststoff gebildet sein kann. Der bekannte Halterahmen weist eine Trägerstruktur mit Auflageschultern und Rasthaken auf, zwischen denen die Leiterplatte formschlüssig gehalten wird. Ferner kann dieser Halterahmen ein federndes Rastelement mit einem Rasthaken aufweisen, das dazu ausgebildet ist, in eine Öffnung eines Gehäuses federnd einzurasten, so dass der Halterahmen mit dem Gehäuse rastend steckverbunden werden kann.

"Die CH 649 884 A5 offenbart ein Befestigungselement für elektronische Flachbaugruppen. Die DE 10 2008 043 457 A1 offenbart einen Platinenträgeranordnung zum Halten einer Schaltplatine mit Berührungssensor. Die US 5 174 780 A offenbart einen schrägen Sockel für Speichermodule."

### Offenbarung der Erfindung

Erfindungsgemäß sind ein Halterahmen zum Anbringen einer Leiterplatte an einem Gehäuse gemäß Anspruch 1 sowie ein Befestigungssystem Anspruch 10.

Weitere Ausführungsformen sind in den abhängigen Ansprüchen angegeben. Alle in den Ansprüchen und der Beschreibung für den Halterahmen angegebenen weiterführenden Merkmale und Wirkungen gelten auch in Bezug auf das Befestigungssystem, und umgekehrt.

Gemäß einem ersten Aspekt ist ein Halterahmen zum Anbringen einer Leiterplatte an einem Gehäuse vorgesehen, wobei der Halterahmen umfasst:
- eine Trägerstruktur für die Leiterplatte;
- mindestens einen Einpressvorsprung, der derart elastisch und/oder plastisch verformbar ist, dass er mit Übermaß in eine Ausnehmung im Gehäuse einpressbar ist, um den Halterahmen am Gehäuse zu befestigen; und
- mindestens ein Federelement, das den mindestens einen Einpressvorsprung mit der Trägerstruktur federnd verbindet.

Dabei kann es vorgesehen sein, dass die Leiterplatte von der Trägerstruktur des Halterahmens lediglich abgestützt oder aber an dieser befestigt werden kann, oder beides. Ein Einpressvorsprung kann in einer Einpressrichtung in die zugehörige Ausnehmung im Gehäuse beispielsweise auf Maß oder auf Anschlag eingepresst werden. Es können neben einem einzigen Einpressvorsprung auch zwei, drei oder mehr über den Halterahmen verteilte Einpressvorsprünge vorgesehen sein, von denen jeder jeweils mit einem Federelement verbunden ist, welches seinerseits mit der Trägerstruktur verbunden ist.

Durch das Vorsehen der Einpressvorsprünge zur Befestigung des Halterahmens am Gehäuse kann erstens die Montage des Halterahmens am Gehäuse deutlich vereinfacht werden. Das liegt an zusätzlichen Toleranzausgleichsmöglichkeiten im Vergleich zur Befestigung mit Befestigungsmitteln wie Schrauben oder Rasthaken, wo in der Regel deutlich höhere Präzisionsanforderungen an Geometrien der zu verbindenden Elemente gelten als bei einer Presspassung. Zweitens kann das Ausbilden von Einpressvorsprüngen im Vergleich zu Rasthaken einfacher sein, weil die Herstellung von Hinterschnitten am Halterahmen und am Gehäuse entfällt. So kann insbesondere beim Herstellen des Halterahmens durch Formgießen mit einer einzelnen Formwerkzeughälfte in eine Richtung entformt werden, so dass beispielsweise keine unerwünschten Entformungsgrate entstehen.

Die Federelemente können insbesondere bewirken, dass die Trägerstruktur nach dem Einpressen der Einpressvorsprünge ins Gehäuse in einer federnden Weise mit dem Gehäuse verbunden ist. Dadurch kann eine stoß- oder schwingungsdämpfende Halterung der Leiterplatte am Gehäuse erzielt werden.

Insgesamt kann daher die obige Kombination mindestens eines Einpressvorsprungs mit mindestens einem Federelement eine deutliche Vereinfachung in der Montage oder Herstellung des Halterahmens und/oder eines Gehäuses, an dem eine Leiterplatte mittels des Halterahmens anzubringen ist, ermöglichen. Gleichzeitig können dabei aber auch hohe mechanische Sicherheitsanforderungen an die Anbringung der Leiterplatte am Gehäuse gewährleistet werden.

Das Gehäuse kann ein Metallgehäuse, insbesondere ein Gußgehäuse, sein. Es kann aber auch zumindest teilweise aus einem anderen Werkstoff, beispielsweise aus Kunststoff, gefertigt sein.

Der Halterahmen kann vollständig oder teilweise aus Kunststoff, insbesondere durch Spritzgießen, hergestellt sein. Die Federelemente und/oder die Einpressvorsprünge können mit der Trägerstruktur einstückig ausgebildet sein. Sie können aus demselben oder einem anderen Werkstoff als die Trägerstruktur sein und an dieser beispielsweise angeformt oder in einer anderen dem Fachmann bekannten Weise damit verbunden sein. Durch die Wahl der Werkstoffe und der geometrischen Ausgestaltung können die Verformbarkeit der Einpressvorsprünge und die Federwirkung der Federelemente spezifisch eingestellt werden.

Es kann beispielsweise vorgesehen sein, dass mindestens eines der Federelemente in einer Einpressrichtung des mit dem Federelement verbundenen Einpressvorsprungs federnd, insbesondere beweglich ausgebildet ist. Alternativ oder zusätzlich kann mindestens eines der Federelemente in mindestens einer zur Einpressrichtung des mit dem Federelement verbundenen Einpressvorsprungs transversalen Richtung federnd, insbesondere beweglich ausgebildet sein. Je nach gegenseitiger Anordnung des Halterahmens, der Leiterplatte und des Gehäuses kann durch eine Federwirkung in einer bestimmten Richtung die Trägerstruktur und damit die Leiterplatte beispielsweise zum Gehäuse hin angezogen werden, um die Leiterplatte am Gehäuse zu halten. Ferner kann eine Beweglichkeit der Federelemente in einer bestimmten Richtung einen zusätzlichen Toleranzausgleich zwischen dem Halterahmen, dem Gehäuse und der Leiterplatte in dieser Richtung ermöglichen. Eine Federung in jeder weiteren Richtung kann zudem zu einer stoß- und schwingungsdämpfenden Wirkung des Halterahmens beitragen.

Erfindungsgemäß ist mindestens eines der Federelemente als ein Biegearm ausgebildet, der an einem Ende fest mit der Trägerstruktur verbunden ist und an dessen freiem anderem Ende einer der Einpressvorsprünge angeordnet ist. Solch ein Biegearm stellt eine Biegefeder dar, wobei eine bestimmte Federwirkung in deren Hauptbiegerichtung und gegebenenfalls auch seitlich davon in einer von der Herstellung her einfachen und räumlich platzsparenden Weise erzielt werden kann. Die entsprechenden Federkräfte können beispielsweise durch Ausgestaltungsparameter der Biegearme wie Länge, Breite, Biegeweg oder relative Position bezüglich der Trägerstruktur eingestellt werden.

Entspricht beispielsweise die Einpressrichtung des Einpressvorsprungs der Hauptbiegerichtung des Biegearms, so ergibt sich eine Federwirkung in der Einpressrichtung. Bei einer schmalen länglichen Ausgestaltung des Biegearms kann ferner eine gewisse Federwirkung und Beweglichkeit des Biegearms in einer zu seiner Hauptbiegerichtung senkrechten Seitenrichtung gegeben sein. Der Biegearm kann insbesondere im Wesentlichen gerade, insbesondere stegförmig oder blattfederförmig, ausgebildet sein. (Hier und nachfolgend wird unter "im Wesentlichen" insbesondere eine herstellungs- oder konstruktionsbedingte mögliche Abweichung von bis zu etwa 10% von betreffenden Abmessungen verstanden.)

Die geschilderten Federwirkungen, insbesondere die seitliche Beweglichkeit, können beispielsweise bei einer Biegearmlänge erreicht werden, die ein Vielfaches, insbesondere mindestens ein Drei-, Fünf- oder Siebenfaches, einer jeden durchschnittlichen Querschnittsabmessung des Biegearms beträgt. Der Durchschnittswert wird dabei entlang einer Längsrichtung des Biegearms gebildet.

Erfindungsgemäß ist eine Flächenerstreckung der Trägerstruktur in zwei Raumrichtungen um ein Vielfaches, insbesondere mindestens ein Drei-, Fünf- oder Siebenfaches, größer als deren Höhenerstreckung in einer hierzu senkrechten dritten Raumrichtung, beispielsweise um eine flächige Leiterplatte abzustützen. Erfindungsgemäß erstrecken sich zwei Biegearme in zwei verschiedeneRichtungen von der Trägerstruktur weg in Richtung von deren Flächenerstreckung. Dies ermöglicht eine insbesondere gleichmäßige Verteilung der Befestigungs- und Federkräfte über die Trägerstrukturfläche, so dass eine gewünschte Stabilität und/oder Federwirkung bereits mit einer minimalen Anzahl von Federelementen und Einpressvorsprüngen erzielbar ist.

Gemäß einer vorteilhaften Weiterbildung erstrecken sich zwei Biegearme in zwei im Wesentlichen entgegengesetzte Richtungen von der Trägerstruktur weg in Richtung von deren Flächenerstreckung.

Grundsätzlich können die Einpressvorsprünge jede geometrische Ausgestaltung haben, die ein Einpressen mit Übermaß in eine Ausnehmung im Gehäuse erlaubt. Insbesondere kann hierzu mindestens einer der Einpressvorsprünge ein oder mehrere seitlich auskragende Verformungselemente, beispielsweise Pressrippen oder -Nasen, aufweisen, die elastisch und/oder plastisch verformbar sind.

Bei spezifischen Ausgestaltungen, bei denen die Leiterplatte an der Trägerstruktur befestigt werden kann, kann die Trägerstruktur hierzu mindestens einen Leiterplatten-Befestigungsvorsprung aufweisen, der derart elastisch und/oder plastisch verformbar ist, dass er mit Übermaß in eine Ausnehmung in der Leiterplatte einpressbar ist. Insbesondere kann mindestens einer der Leiterplatten-Befestigungsvorsprünge hierzu ein oder mehrere seitlich auskragende Verformungselemente wie Pressrippen oder -Nasen haben, die elastisch und/oder plastisch verformbar sind. Auch im Übrigen kann hier das in Bezug auf die Einpressvorsprünge Ausgeführte sinngemäß gelten.

Gemäß einem weiteren Aspekt ist ein Befestigungssystem für eine Leiterplatte vorgesehen, das Folgendes umfasst:
- einen Halterahmen einer hierin dargelegten Art sowie
- ein Gehäuse, das mindestens eine Ausnehmung, insbesondere eine längliche Nut, zum Aufnehmen des mindestens einen Einpressvorsprungs des Halterahmens aufweist. Dabei entspricht eine Abmessung des mindestens einen Einpressvorsprungs gegenüber einer Abmessung der mindestens einen Ausnehmung einer Übermaßpassung, sodass der mindestens eine Einpressvorsprung in die mindestens eine Ausnehmung mit Übermaß einpressbar ist.

Um einen zusätzlichen Toleranzausgleich zwischen dem Gehäuse, dem Halterahmen und der Leiterplatte zu ermöglichen, kann mindestens eine der Ausnehmungen im Gehäuse in mindestens einer Variabilitätsrichtung eine derartige Variabilitätserstreckung aufweisen, dass einer der Einspressvorsprünge in diese Ausnehmung an mehreren verschiedenen Einpresspositionen entlang der Variabilitätserstreckung der Ausnehmung einpressbar ist.

Eine solche Variabilitätsrichtung kann beispielsweise einer Einpressrichtung des Einpressvorsprungs in die Ausnehmung entsprechen, so dass eine Einpresstiefe und damit insbesondere ein Abstand des Halterahmens vom Gehäuse unterschiedlich gewählt werden kann. Alternativ oder zusätzlich kann für einen lateralen Toleranzausgleich eine Variabilitätsrichtung transversal zur Einpressrichtung sein, was beispielsweise durch eine längliche Nut im Gehäuse realisierbar ist.

### Kurzbeschreibung der Zeichnungen

Ausführungsformen werden nachfolgend anhand des in beigefügten Zeichnungen dargestellten Beispiels näher erläutert. Die Zeichnungen sind rein schematisch, sie sind insbesondere nicht als maßstabsgetreu zu lesen. Es zeigen:
- Figur 1: einen Halterahmen und eine damit an einem Gehäuse anzubringende Leiterplatte; und
- Figur 2: ein Gehäuse mit der darin mittels des Halterahmens der Fig. 1 angebrachten Leiterplatte der Fig. 1.

### Beschreibung einer Ausführungsform

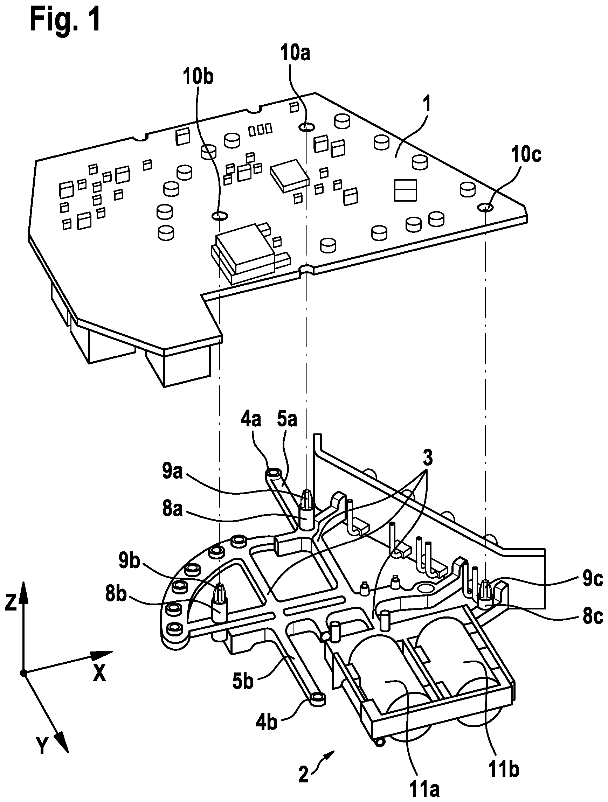

Figur 1 zeigt schematisch eine Leiterplatte 1 und einen Halterahmen 2 zum Anbringen der Leiterplatte 1 an einem Gehäuse in perspektivischer Explosionsdarstellung. Der Halterahmen 2 ist in diesem Beispiel einstückig aus Kunststoff gebildet, beispielsweise durch Spritzgießen.

Der Halterahmen 2 weist eine Trägerstruktur 3 für die Leiterplatte 1 auf, die mehrere ungefähr in einer Ebene liegende, miteinander verbundene Stege und Streben zum Abstützen der flächigen Leiterplatte 1 umfasst. Demensprechend ist eine Flächenerstreckung der Trägerstruktur 3 in einer eingezeichneten x-y-Ebene um ein Vielfaches größer als deren Höhenerstreckung in einer hierzu senkrechten z-Richtung.

Der Halterahmen 2 weist zu dessen Befestigung am Gehäuse zwei Einpressvorsprünge 4a und 4b auf, die jeweils durch ein Federelement 5a bzw. 5b mit der Trägerstruktur 3 federnd verbunden sind. Die Federelemente 5a und 5b stellen dabei Biegearme in Form schmaler gerader Stege dar, die sich ungefähr in der y-Richtung in zwei entgegengesetzten Richtungen von der Trägerstuktur 3 weg erstrecken. Die Einpressvorsprünge 4a und 4b sind an den jeweiligen freien Enden der Federelemente 5a und 5b angeordnet und erstrecken sich rein beispielhaft ungefähr in der z-Richtung, die deren Einpressrichtung entsprechen kann.

Jedes Federelement 5a und 5b hat rein beispielhaft einen etwa rechteckigen x-z-Querschnitt, dessen Breite in der x-Richtung etwa oder mehr als doppelt so groß wie dessen Dicke in der z-Richtung ist, was eine Hauptbiegerichtung des Biegearms in der z-Richtung ergibt. Beim Biegen des Federelements 5a oder 5b in der z-Richtung entsteht daher eine Federwirkung in der z- und y-Richtung. Aufgrund der schmalen länglichen Ausgestaltung sind die Federelemente 5a und 5b zusätzlich in der x-Richtung federnd und beweglich. Somit können die Federelemente 5a und 5b in allen Richtungen federn und so zur oben erwähnten Stoß- und Schwingungsdämpfung der Leiterplatte 1 im Gehäuse beitragen.

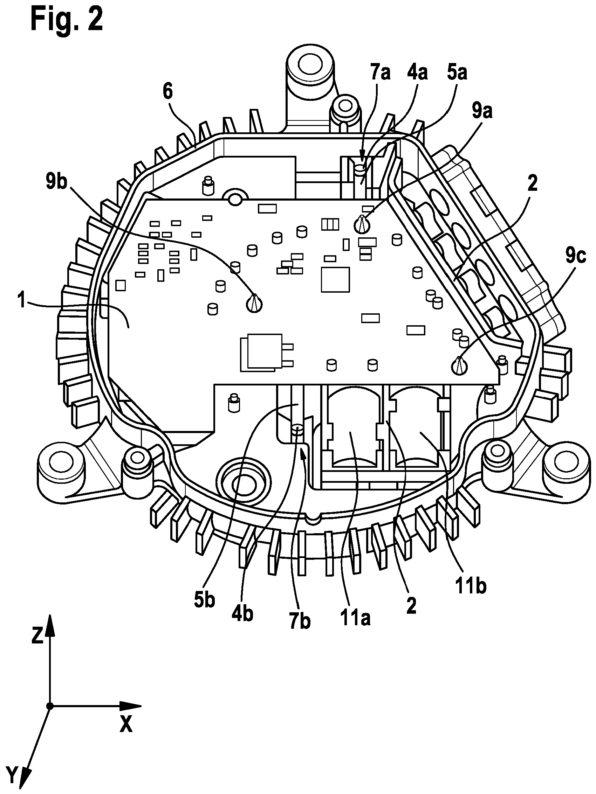

Figur 2 zeigt schematisch eine perspektivische Draufsicht auf ein Gehäuse 6, in dem die Leiterplatte 1 aus Fig. 1 mittels des Halterahmens 2 aus Fig. 1 angebracht ist. Das Gehäuse 6 ist in diesem Beispiel ein Gußgehäuse aus Metall, beispielsweise aus Aluminium.

Der Halterahmen 2 ist am Gehäuse 6 durch die zwei Einpressvorsprünge 4a und 4b befestigt, die mit Übermaß in zugehörige Ausnehmungen 7a und 7b im Gehäuse 6 eingepresst sind. Rein beispielhaft stellen die Einpressvorsprünge 4a und 4b ungefähr zylindrische Dome dar. Sie weisen in den Figuren nicht im Detail dargestellte Verformungselemente, beispielsweise Verdickungen gegenüber einer regelmäßigen Zylinderform durch seitlich auskragende Pressnasen oder Pressrippen, auf, die beim Einpressen in die Ausnehmungen 7a und 7b elastisch und/oder plastisch verformt wurden.

Die Ausnehmungen 7a und 7b im Gehäuse 6 sind in diesem Beispiel als längliche Nuten ausgebildet, die sich in der y-Richtung erstrecken. Entlang dieser Variabilitätserstreckung der Ausnehmung 7a oder 7b kann der Einpressvorsprung 4a bzw. 4b an verschiedenen Positionen eingepresst werden. Das ermöglicht einen Toleranzausgleich zwischen der Leiterplatte 1, dem Halterahmen 2 und dem Gehäuse 6 in der y-Richtung. Die oben erwähnte seitliche Beweglichkeit der Federelemente 5a und 5b sorgt zusätzlich für einen Toleranzausgleich zwischen der Leiterplatte 1, dem Halterahmen 2 und dem Gehäuse 6 in der x-Richtung.

Ferner können die Einpresspositionen der Einpressvorsprünge 4a bzw. 4b entlang der Ausnehmung 7a bzw. 7b so gewählt werden, dass die Federelemente 5a und 5b gebogen und damit vorgespannt sind, um die Leiterplatte 1 gegen das Gehäuse 6 anzuziehen.

Um die Leiterplatte 1 an der Trägerstruktur 3 des Halterahmens 2 zu befestigen, weist die Trägerstruktur 3 in diesem Beispiel zusätzlich drei Leiterplatten-Befestigungsvorsprünge 8a, 8b und 8c in Form ungefähr zylindrischer Dome mit in den Figuren erkennbaren seitlich auskragenden Verformungselementen in Form von Pressrippen an Domspitzen 9a, 9b und 9c auf. Die Leiterplatte 1 weist an entsprechenden Positionen Ausnehmungen 10a, 10b und 10c in Form von Durchgangsöffnungen auf, in die die Domspitzen 9a, 9b und 9c beim Aufpressen der Leiterplatte auf die Trägerstruktur 3 eingepresst werden.

Weiterhin können in der Trägerstruktur 3 Elektronik-Komponenten für die Leiterplatte 1, wie beispielsweise Kondensatoren 11a und 11b, befestigt sein.

## Patentansprüche

1. Halterahmen (2) zum Anbringen einer Leiterplatte (1) an einem Gehäuse (6), umfassend:
• eine Trägerstruktur (3) für die Leiterplatte (1);
• mindestens einen Einpressvorsprung (4a, 4b), der derart elastisch und/oder plastisch verformbar ist, dass er mit Übermaß in eine Ausnehmung (7a, 7b) im Gehäuse (6) einpressbar ist, um den Halterahmen (2) am Gehäuse (6) zu befestigen; und
• mindestens ein Federelement (5a, 5b), das den mindestens einen Einpressvorsprung (4a, 4b) mit der Trägerstruktur (3) federnd verbindet, wobei
• mindestens eines der Federelemente (5a, 5b) als ein Biegearm ausgebildet ist, der an einem Ende fest mit der Trägerstruktur (3) verbunden ist und an dessen freiem anderem Ende einer der Einpressvorsprünge (4a, 4b) angeordnet ist;
**dadurch gekennzeichnet, dass**
• eine Flächenerstreckung der Trägerstruktur (3) in zwei Raumrichtungen (x, y) um ein Vielfaches größer als deren Höhenerstreckung in einer hierzu senkrechten dritten Raumrichtung (z) ist; und dass
• sich zwei der als Biegearme ausgebildeten Federelemente in zwei verschiedene Richtungen von der Trägerstruktur (3) weg in Richtung (y) von deren Flächenerstreckung erstrecken.

2. Halterahmen (2) nach Anspruch 1, wobei
• mindestens eines der Federelemente (5a, 5b) in einer Einpressrichtung (z) des mit dem Federelement (5a, 5b) verbundenen Einpressvorsprungs (4a, 4b) federnd, insbesondere beweglich ausgebildet ist und/oder
• mindestens eines der Federelemente (5a, 5b) in mindestens einer zur Einpressrichtung (z) des mit dem Federelement (5a, 5b) verbundenen Einpressvorsprungs (4a, 4b) transversalen Richtung (x) federnd, insbesondere beweglich ausgebildet ist.

3. Halterahmen (2) nach Anspruch 1, wobei der Biegearm im Wesentlichen gerade, insbesondere stegförmig, ausgebildet ist.

4. Halterahmen (2) nach Anspruch 1 oder 3, wobei eine Biegearmlänge ein Vielfaches, insbesondere mindestens ein Drei-, Fünf- oder Siebenfaches, einer jeden durchschnittlichen Querschnittsabmessung des Biegearms beträgt.

5. Halterahmen (2) nach einem der Ansprüche 1 bis 4, wobei
• sich zwei Biegearme in zwei im Wesentlichen entgegengesetzte Richtungen von der Trägerstruktur (3) weg in Richtung (y) von deren Flächenerstreckung erstrecken.

6. Halterahmen (2) nach einem der vorhergehenden Ansprüche, wobei mindestens einer der Einpressvorsprünge (4a, 4b) ein oder mehrere seitlich auskragende Verformungselemente, insbesondere Pressrippen oder Pressnasen, aufweist, die elastisch und/oder plastisch verformbar sind, wodurch der Einpressvorsprung (4a, 4b) mit Übermaß in eine Ausnehmung (7a, 7b) im Gehäuse (6) einpressbar ist.

7. Halterahmen (2) nach einem der vorhergehenden Ansprüche, wobei die Trägerstruktur (3) mindestens einen Leiterplatten-Befestigungsvorsprung (8a, 8b, 8c) aufweist, der derart elastisch und/oder plastisch verformbar ist, dass er mit Übermaß in eine Ausnehmung (10a, 10b, 10c) in der Leiterplatte (1) einpressbar ist, um die Leiterplatte (1) an der Trägerstruktur (3) zu befestigen.

8. Halterahmen (2) nach Anspruch 7, wobei mindestens einer der Leiterplatten-Befestigungsvorsprünge (8a, 8b, 8c) ein oder mehrere seitlich auskragende Verformungselemente, insbesondere Pressrippen oder Pressnasen, aufweist, die elastisch und/oder plastisch verformbar sind, wodurch der Leiterplatten-Befestigungsvorsprung (8a, 8b, 8c) mit Übermaß in eine Ausnehmung (10a, 10b, 10c) in der Leiterplatte (1) einpressbar ist.

9. Halterahmen (2) nach einem der vorhergehenden Ansprüche, der zumindest teilweise aus Kunststoff, insbesondere durch Spritzgießen, hergestellt ist.

10. Befestigungssystem für eine Leiterplatte (1), umfassend:
• einen Halterahmen (2) nach einem der vorhergehenden Ansprüche; und
• ein Gehäuse (6), das mindestens eine Ausnehmung (7a, 7b), insbesondere eine längliche Nut, zum Aufnehmen des mindestens einen Einpressvorsprungs (4a, 4b) des Halterahmens (2) aufweist;
• wobei eine Abmessung des mindestens einen Einpressvorsprungs (4a, 4b) gegenüber einer Abmessung der mindestens einen Ausnehmung (7a, 7b) einer Übermaßpassung entspricht, sodass der mindestens eine Einpressvorsprung (4a, 4b) in die mindestens eine Ausnehmung (7a, 7b) mit Übermaß einpressbar ist.

11. Befestigungssystem nach Anspruch 10, wobei mindestens eine der Ausnehmungen (7a, 7b) im Gehäuse (6) in mindestens einer Variabilitätsrichtung (y) eine derartige Variabilitätserstreckung aufweist, dass einer der Einspressvorsprünge (4a, 4b) in diese Ausnehmung (7a, 7b) an mehreren verschiedenen Einpresspositionen entlang der Variabilitätserstreckung der Ausnehmung (7a, 7b) einpressbar ist.

12. Befestigungssystem nach Anspruch 11, wobei die mindestens eine Variabilitätsrichtung (y) einer Einpressrichtung des Einpressvorsprungs (4a, 4b) in die Ausnehmung (7a, 7b) und/oder einer hierzu transversalen, insbesondere im Wesentlichen senkrechten, Richtung (y) entspricht.

## Claims

1. Holding frame (2) for attaching a printed circuit board (1) to a housing (6), comprising:
• a carrier structure (3) for the printed circuit board (1);
• at least one press-in projection (4a, 4b), which is elastically and/or plastically deformable so as to be pressable with an oversize into a cutout (7a, 7b) in the housing (6) in order to fasten the holding frame (2) to the housing (6); and
• at least one spring element (5a, 5b), which resiliently connects the at least one press-in projection (4a, 4b) to the carrier structure (3),
wherein
• at least one of the spring elements (5a, 5b) is formed as a bending arm which, at one end, is connected permanently to the carrier structure (3) and, on the free, other end of which, one of the press-in projections (4a, 4b) is arranged;
**characterized in that**
• an areal extent of the carrier structure (3) in two spatial directions (x, y) is a number of times greater than the height extent thereof in a third spatial direction (z) perpendicular thereto; and **in that**
• two of the spring elements formed as bending arms extend in two different directions away from the carrier structure (3) in a direction (y) of its areal extent.

2. Holding frame (2) according to Claim 1, wherein
• at least one of the spring elements (5a, 5b) is configured to be resilient, in particular movable, in a direction of pressing-in (z) of the press-in projection (4a, 4b) connected to the spring element (5a, 5b), and/or
• at least one of the spring elements (5a, 5b) is configured to be resilient, in particular movable, in at least one direction (x) which is transverse to the direction of pressing-in (z) of the press-in projection (4a, 4b) connected to the spring element (5a, 5b).

3. Holding frame (2) according to Claim 1, wherein the bending arm is of substantially straight, in particular web-like, form.

4. Holding frame (2) according to Claim 1 or 3, wherein a bending-arm length is a number of times, in particular at least three, five or seven times, an average cross-sectional dimension of the bending arm in this case.

5. Holding frame (2) according to one of Claims 1 to 4, wherein
• two bending arms extend in two substantially opposite directions away from the carrier structure (3) in a direction (y) of its areal extent.

6. Holding frame (2) according to one of the preceding claims, wherein at least one of the press-in projections (4a, 4b) has one or more laterally projecting deformation elements, in particular pressing ribs or pressing noses, which are elastically and/or plastically deformable, whereby the press-in projection (4a, 4b) is pressable with an oversize into a cutout (7a, 7b) in the housing (6).

7. Holding frame (2) according to one of the preceding claims, wherein the carrier structure (3) has at least one printed-circuit-board fastening projection (8a, 8b, 8c) which is elastically and/or plastically deformable so as to be pressable with an oversize into a cutout (10a, 10b, 10c) in the printed circuit board (1) in order to fasten the printed circuit board (1) to the carrier structure (3).

8. Holding frame (2) according to Claim 7, wherein at least one of the printed-circuit-board fastening projections (8a, 8b, 8c) has one or more laterally projecting deformation elements, in particular pressing ribs or pressing noses, which are elastically and/or plastically deformable, whereby the printed-circuit-board fastening projection (8a, 8b, 8c) is pressable with an oversize into a cutout (10a, 10b, 10c) in the printed circuit board (1).

9. Holding frame (2) according to one of the preceding claims, which holding frame is produced at least partially from plastic, in particular by injection moulding.

10. Fastening system for a printed circuit board (1), comprising:
• a holding frame (2) according to one of the preceding claims; and
• a housing (6), which has at least one cutout (7a, 7b), in particular an elongated groove, for receiving the at least one press-in projection (4a, 4b) of the holding frame (2);
• wherein a dimension of the at least one press-in projection (4a, 4b) in comparison with a dimension of the at least one cutout (7a, 7b) corresponds to an interference fit, so that the at least one press-in projection (4a, 4b) is pressable with an oversize into the at least one cutout (7a, 7b).

11. Fastening system according to Claim 10, wherein at least one of the cutouts (7a, 7b) in the housing (6) has in at least one direction of variability (y) a variability extent such that one of the press-in projections (4a, 4b) is pressable into this cutout (7a, 7b) at multiple different press-in positions along the variability extent of the cutout (7a, 7b).

12. Fastening system according to Claim 11, wherein the at least one direction of variability (y) corresponds to a direction of pressing-in of the press-in projection (4a, 4b) into the cutout (7a, 7b) and/or to a direction (y) which is transverse, in particular substantially perpendicular, thereto.

## Revendications

1. Cadre de maintien (2) permettant de monter une carte de circuits imprimés (1) sur un boîtier (6), comprenant :
• une structure porteuse (3) pour la carte de circuits imprimés (1) ;
• au moins une saillie d'enfoncement (4a, 4b) qui est déformable de manière élastique et/ou plastique de telle sorte qu'elle peut être enfoncée à surmesure dans un évidement (7a, 7b) dans le boîtier (6) afin de fixer le cadre de maintien (2) au boîtier (6) ; et
• au moins un élément faisant ressort (5a, 5b) qui relie à ressort ladite au moins une saillie d'enfoncement (4a, 4b) à la structure porteuse (3),
dans lequel
• au moins l'un des éléments faisant ressort (5a, 5b) est réalisé sous forme de bras flexible qui est à une extrémité relié solidement à la structure porteuse (3) et à l'autre extrémité libre duquel est disposée l'une des saillies d'enfoncement (4a, 4b) ;
**caractérisé en ce que**
• une étendue superficielle de la structure porteuse (3) dans deux directions spatiales (x, y) est plusieurs fois plus grande qu'à son étendue en hauteur dans une troisième direction spatiale (z) perpendiculaire à celle-ci ; et **en ce que**
• deux des éléments faisant ressort réalisés sous forme de bras flexibles s'étendent dans deux directions différentes en s'éloignant de la structure porteuse (3) dans la direction (y) à partir de leur étendue superficielle.

2. Cadre de maintien (2) selon la revendication 1, dans lequel
• au moins l'un des éléments faisant ressort (5a, 5b) est réalisé à ressort, en particulier de manière mobile, dans une direction d'enfoncement (z) de la saillie d'enfoncement (4a, 4b) reliée à l'élément faisant ressort (5a, 5b), et/ou
• au moins l'un des éléments faisant ressort (5a, 5b) est réalisé à ressort, en particulier de manière mobile, dans au moins une direction (x) transversale à la direction d'enfoncement (z) de la saillie d'enfoncement (4a, 4b) reliée à l'élément faisant ressort (5a, 5b).

3. Cadre de maintien (2) selon la revendication 1, dans lequel le bras flexible est réalisé de manière substantiellement droite, en particulier en forme d'entretoise.

4. Cadre de maintien (2) selon la revendication 1 ou 3, dans lequel une longueur de bras flexible est égale à plusieurs fois, en particulier à trois, cinq ou sept fois, chaque dimension de section transversale moyenne du bras flexible.

5. Cadre de maintien (2) selon l'une quelconque des revendications 1 à 4, dans lequel
• deux bras flexibles s'étendent dans deux directions substantiellement opposées en s'éloignant de la structure porteuse (3) dans la direction (y) à partir de leur étendue superficielle.

6. Cadre de maintien (2) selon l'une quelconque des revendications précédentes, dans lequel au moins l'une des saillies d'enfoncement (4a, 4b) présente un ou plusieurs éléments de déformation dépassant latéralement, en particulier des nervures de compression ou des becs de compression qui sont déformables de manière élastique et/ou plastique de sorte que la saillie d'enfoncement (4a, 4b) peut être enfoncée à surmesure dans un évidement (7a, 7b) dans le boîtier (6).

7. Cadre de maintien (2) selon l'une quelconque des revendications précédentes, dans lequel la structure porteuse (3) présente au moins une saillie de fixation de carte de circuits imprimés (8a, 8b, 8c) qui est déformable de manière élastique et/ou plastique de telle sorte qu'elle peut être enfoncée à surmesure dans un évidement (10a, 10b, 10c) dans la carte de circuits imprimés (1) afin de fixer la carte de circuits imprimés (1) à la structure porteuse (3).

8. Cadre de maintien (2) selon la revendication 7, dans lequel au moins l'une des saillies de fixation de carte de circuits imprimés (8a, 8b, 8c) présente un ou plusieurs éléments de déformation dépassant latéralement, en particulier des nervures de compression ou des becs de compression qui sont déformables de manière élastique et/ou plastique de sorte que la saillie de fixation de carte de circuits imprimés (8a, 8b, 8c) peut être enfoncée à surmesure dans un évidement (10a, 10b, 10c) dans la carte de circuits imprimés (1).

9. Cadre de maintien (2) selon l'une quelconque des revendications précédentes qui est fabriqué au moins partiellement en matière plastique, en particulier par moulage par injection.

10. Système de fixation pour une carte de circuits imprimés (1), comprenant :
• un cadre de maintien (2) selon l'une quelconque des revendications précédentes ; et
• un boîtier (6) qui présente au moins un évidement (7a, 7b), en particulier une rainure allongée, pour recevoir ladite au moins une saillie d'enfoncement (4a, 4b) du cadre de maintien (2) ;
• dans lequel une dimension de ladite au moins une saillie d'enfoncement (4a, 4b) par rapport à une dimension dudit au moins un évidement (7a, 7b) correspond à un ajustement à surmesure de sorte que ladite au moins une saillie d'enfoncement (4a, 4b) peut être enfoncée à surmesure dans ledit au moins un évidement (7a, 7b).

11. Système de fixation selon la revendication 10, dans lequel au moins l'un des évidements (7a, 7b) dans le boîtier (6) présente dans au moins une direction de variabilité (y) une telle étendue de variabilité que l'une des saillies d'enfoncement (4a, 4b) peut être enfoncée dans cet évidement (7a, 7b) dans plusieurs positions d'enfoncement différentes le long de l'étendue de variabilité de l'évidement (7a, 7b).

12. Système de fixation selon la revendication 11, dans lequel ladite au moins une direction de variabilité (y) correspond à une direction d'enfoncement de la saillie d'enfoncement (4a, 4b) dans l'évidement (7a, 7b) et/ou à une direction (y) transversale, en particulier perpendiculaire, à celle-ci.
